# EUROPÄISCHE PATENTSCHRIFT

(11) **EP 3 884 552 B1**
(45) Veröffentlichungstag und Bekanntmachung des Hinweises auf die Patenterteilung: **04.10.2023**
(21) Anmeldenummer: 19809776.8
(22) Anmeldetag: 25.11.2019
(51) Int. Cl.: H02B 1/56, H05K 7/20, H05K 7/14

(54) **UNTERWASSER-KÜHLVORRICHTUNG**
UNDERWATER COOLING DEVICE
DISPOSITIF DE REFROIDISSEMENT SOUS L'EAU

(30) Priorität: 23.11.2018 DE 102018129593
(43) Veröffentlichungstag der Anmeldung: 29.09.2021
(73) Patentinhaber: TenneT TSO GmbH, 95448 Bayreuth (DE)
(72) Erfinder: LÖBERMANN, Matthias, 31515 Wunstorf (DE)
(74) Vertreter: Scheffler, Jörg
(86) Internationale Anmeldenummer: PCT/EP2019/082385
(87) Internationale Veröffentlichungsnummer: WO 2020/104700

(56) Entgegenhaltungen:
- EP-A1- 2 487 327
- EP-A1- 2 487 327
- JP-A- S5 846 261
- SE-A1- 1 400 342
- SE-A1- 1 400 342
- US-A- 6 145 584
- US-A- 6 145 584
- US-A1- 2008 302 115
- US-A1- 2010 254 087
- US-A1- 2010 254 087
- US-A1- 2016 381 840

## Beschreibung

Die vorliegende Erfindung betrifft eine Unterwasser-Kühlvorrichtung für elektrische und/oder chemische Wärmeerzeuger.

Bei einer Energieübertragung von einer Offshore-Stromerzeugungseinheit (z. B. ein Offshore-Windpark) wird die Übertragungskapazität durch eine Verbindung zwischen einer Seestation und einer Landstation bereitgestellt. Die Seestation weist elektrische Elemente der Leistungselektronik wie z.B. Transformatoren, Umrichter, Gleichrichter, IGBT, Schaltschränke etc. sowie aufwendige Sekundärsysteme insbesondere zur Bereitstellung von Kühlsystemen für die elektrischen Elemente auf. Diese Kühlsysteme dienen der Verlustwärmeabfuhr infolge des Betriebs der elektrischen Elemente. Eine Seewasserentnahme für die Bereitstellung zur Abfuhr der durch die Leistungselektronik anfallenden Verlustwärme kann durch eine Vielzahl von prozessunterstützenden verfügbarkeitswichtigen Nebensystemen bereitgestellt werden. Die Seestation kann weitere Systeme für logistische Anforderungen der Instandhaltung sowie zur Aufnahme von Instandhaltungspersonal bereitstellen. Die derzeitige Ausgestaltung der Offshore-Plattformen ist jedoch sowohl bei Errichtung als auch im anschließenden Betrieb kostentreibend. Darüber hinaus birgt der Personaltransfer auf die Offshore-Arbeitsstätten ein latentes Arbeitssicherheitsrisiko.

US2010254087A1, EP2487327A1 und US6145584A offenbaren Unterwasser-Kühlvorrichtungen für elektrische Module, wobei die Zirkulation des Kühlfluids durch einen inneren Kaminschacht die Wärmeableitung erhöht.

SE1400342A1 und US2008302115A1 zeigen zusätzliche Unterwasser-Kühlvorrichtungen für elektrische Komponenten, jedoch wird in diesem Fall die Effizienz der Wärmeabfuhr über externe, außerhalb der Behälter angeordnete Kaminschächte erhöht.

Es ist eine Aufgabe der vorliegenden Erfindung, die Kühlung von wärmeerzeugenden elektrischen und/oder chemischen Einheiten im Offshore-Bereich zu verbessern.

Diese Aufgabe wird durch eine Unterwasser-Kühlvorrichtung nach Anspruch 1 gelöst.

Die Unterwasser-Kühlvorrichtung weist einen Druckbehälter zur Aufnahme mindestens eines elektrischen oder chemischen Wärmeerzeugers auf. Der Druckbehälter ist mit einem Primärkühlmittel, insbesondere einem Gas, gefüllt. Die Kühlvorrichtung weist ferner eine thermische Isoliereinheit in Form eines Innenkaminzuges und eine thermische Isoliereinheit außerhalb des Druckbehälters beispielweise in Form eines Außenkaminzuges auf.

Das Primärkühlmittel innerhalb des Druckbehälters strömt an den Wärmeerzeugern vorbei, welche innerhalb des ersten Kaminschachtes bzw. Kaminzuges angeordnet sind und wird dabei erwärmt. Anschließend strömt das Primärkühlmittel an der Wandung des Druckbehälters wieder nach unten. Der Druckbehälter ist zusammen mit dem Außenkaminschacht bzw. Kaminzug in Wasser, beispielsweise Seewasser, platziert, so dass die Wandung des Druckbehälters als Wärmetauscher fungiert, und die durch das Primärkühlmittel aufgenommene Wärme wird durch die Wandung des Druckbehälters an das Seewasser abgegeben, welches den Druckbehälter umgibt. Das Seewasser innerhalb des äußeren Kaminzuges bzw. Kaminschachtes wird erwärmt und strömt nach oben. Wenn es den Kaminschacht verlassen hat, dann kühlt es ab und strömt wieder nach unten. Somit wird eine Unterwasserkühlvorrichtung vorgesehen, welche einen doppelten Kamineffekt zur Kühlung von Wärmeerzeugern verwendet. Die erste Kaminströmung befindet sich innerhalb des Druckbehälters und die zweite Kaminströmung erfolgt außerhalb des Druckbehälters.

Die elektrischen Elemente des Stromübertragungssystems oder die Prozessstufen chemischer Umwandlungen (z. B Elektrolyseure, Katalysatoren, Vorwärmer, Wäscher, Kühler, Prozessproduktspeicherbehälter) können in mehrere einzelne Kühlvorrichtungen oder Kühlmodule aufgeteilt werden. Das Primärkühlmedium umströmt die elektrischen Wärmeerzeuger (z.B. Leistungselektronik) oder die chemischen Wärmeerzeuger (z. B. Prozessstufe als Wärmequelle) innerhalb des Kühlbehältermoduls im Naturumlauf eines geschlossenen Kreislaufes (Schwerkraftheizungsprinzip / Kamineffekt). Als Kühlmedium kann ein Inertgas verwendet werden. Das Gas und der elektrische Wärmeerzeuger (z. B. Leistungselektronik) befinden sich in einem Druckbehälter. Der Behälterinnendruck kann beliebig zur Anpassung der Kühlleistung einerseits und zur Anpassung an den hydrostatischen Druck des Sekundärkühlmediums (in der Regel Seewasser) andererseits eingestellt werden. Die elektrischen wärmeerzeugenden Elemente innerhalb des Druckbehälters befinden sich in einem inneren Gefäß/Kaminschacht, der den warmen Teil mit den elektrischen Elementen von dem kalten Teil (Druckbehälterwand) trennt. Das Primärkühlmedium zirkuliert frei durch das innere Gefäß. Der Druckbehälter befindet sich im Sekundärkühlmedium (Seewasser).

Gemäß einem Aspekt der vorliegenden Erfindung können Verfahren mit chemischen und oder elektrochemischen Umwandlungen (z.B. Haber-Bosch Verfahren) ganz oder teilweise unter der Wasseroberfläche installiert werden.

Als Isolierbehältermodul kann das Kühlmedium auch Isoliermedium sein oder der Behälter wird evakuiert und ins technische Vakuum gebracht.

Gemäß einem Aspekt der vorliegenden Erfindung weist der Druckbehälter eine Wandung auf, welche als Wärmetauscher fungiert. Zur Verbesserung der Effizienz des Wärmetauschers kann die Wandung so ausgestaltet sein, dass die wärmeaufnehmende und wärmeabgebende Oberfläche vergrößert wird. Dies kann beispielsweise durch Kühlrippen erfolgen, welche sowohl innen als auch außen an der Wandung des Druckbehälters vorgesehen sein können.

Gemäß einem Aspekt der vorliegenden Erfindung wird ein Kühlsystem mit mindestens einer Unterwasser-Kühlvorrichtung vorgesehen, welche mittels einer Verfahreinheit nach oben und unten befördert werden kann. Die Unterwasser-Kühlvorrichtung ist an der Verfahreinheit befestigt.

Gemäß einem Aspekt der vorliegenden Erfindung kann ein erstes Ende, nämlich das untere Ende, des Druckbehälters so ausgestaltet sein, dass es in dem Seebett bzw. dem Untergrund verankert bzw. befestigt werden kann.

Weitere Ausgestaltungen der Erfindung sind Gegenstand der Unteransprüche.

Vorteile und Ausführungsbeispiele der Erfindung werden nachstehend unter Bezugnahme auf die Zeichnung näher erläutert.
- Fig. 1: zeigt eine schematische Schnittansicht einer Unterwasser-Kühlvorrichtung gemäß einem ersten Ausführungsbeispiel,
- Fig. 2: zeigt eine schematische Schnittansicht einer Unterwasser-Kühlvorrichtung gemäß einem zweiten Ausführungsbeispiel, und
- Fig. 3: zeigt eine schematische Darstellung eines Unterwasser-Kühlsystems gemäß einem dritten Ausführungsbeispiel.

Gemäß der Erfindung wird eine Unterwasser-Kühlvorrichtung für Wärmeerzeuger vorgesehen. Diese Wärmeerzeuger können elektrische Wärmeerzeuger oder chemische Wärmeerzeuger darstellen. Für den Aufbau und die Funktion der Unterwasser-Kühlvorrichtung kommt es hierbei nicht darauf an, ob es sich um elektrische Wärmeerzeuger oder chemische Wärmeerzeuger handelt. Die erfindungsgemäße Unterwasser-Kühlvorrichtung kann zum Kühlen sowohl von elektrischen Wärmeerzeugern als auch chemischen Wärmeerzeugern verwendet werden. Die Unterwasser-Kühlvorrichtung wird typischerweise im Wasser versenkt, so dass das Wasser, beispielsweise Seewasser, als sekundäres Kühlmedium dienen kann.

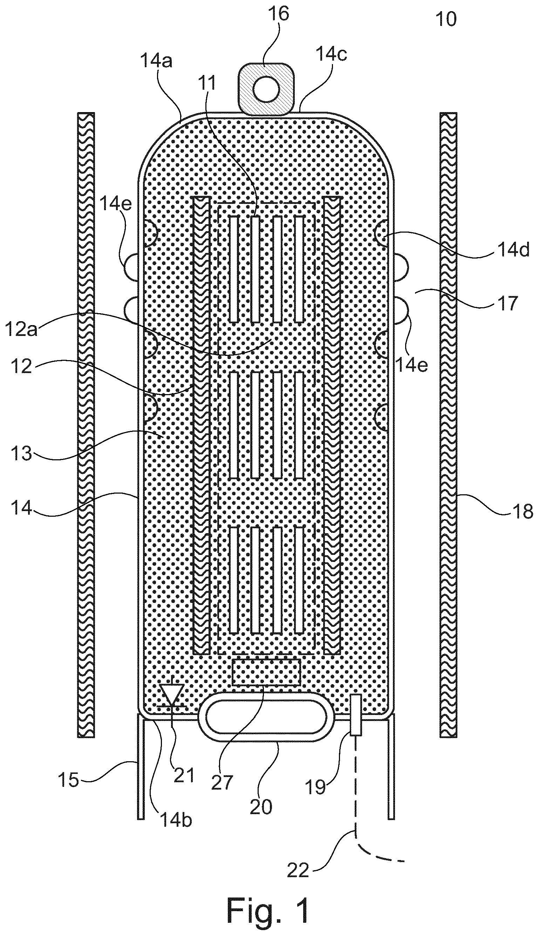

Fig. 1 zeigt eine schematische Schnittansicht einer Unterwasser-Kühlvorrichtung gemäß einem ersten Ausführungsbeispiel. Die Unterwasser-Kühlvorrichtung 10weist einen Druckbehälter 14 mit einem Primärkühlmedium 13 sowie eine Anzahl von elektrischen oder chemischen wärmeerzeugenden Elementen 11 auf. Optional sind die elektrischen oder chemischen wärmeerzeugenden Elemente 11 im Wesentlichen in der Mitte des Druckbehälters 14 angeordnet. Um die elektrischen oder chemischen wärmeerzeugenden Elemente 11 ist ein beispielsweise zylindrisch ausgeformter Innenkaminzug oder Innenkaminschacht 12 vorgesehen. Der Innenkaminschacht 12 ist beispielsweise als Hohlzylinder ausgestaltet und umgibt zumindest teilweise einen Wärmeerzeuger-Aufnahmebereich 12a.

An dem Druckbehälter 14 kann optional ein Lastanschlag 16 an seinem oberen Ende 14c vorgesehen sein. Der Druckbehälter 14 weist vorzugsweise eine Tauchglockenkappe 15 an seinem ersten (unteren) Ende 14b auf. Die Tauchglockenkappe 15 kann optional mit einer Schutzgasatmosphäre gefüllt sein. Im Bereich der Tauchglockenkappe 15 kann ein druckdichtes Kabelschott 19 mit Kabelsteckverbindungen sowie eine druckdichte Revisionsöffnung 20 und eine Ventilgruppe 21 für die Befüllung und Evakuierung des Primärkühlmittels (z. B. CO₂) vorgesehen sein. Die Tauchglocke 15 kann z. B. Füße aufweisen, die in dem Boden befestigbar sind.

Außen um den Druckbehälter 14 ist ein Außenkaminzug 18 vorgesehen. Der Außenkaminzug 18 ist als ein Hohlzylinder ausgestaltet.

Optional kann der Innenkaminzug 12 elektrisch und thermisch isoliert sein. Der Außenkaminzug 18 ist thermisch isoliert.

Die Unterwasser-Kühlvorrichtung 10 wird beim Betrieb im Wasser versenkt, so dass ein Sekundärkühlmittel 17 (z. B. Seewasser) den Druckbehälter 14 sowie den Außenkaminzug 18 umgibt.

Die Kabel 22 werden am unteren Teil des Druckbehälters 14 durch ein Kabelschott 19 unter die Tauchglockenkappe 15, die die Funktion einer Flutungsbarriere hat, an der Tauchglockenkappeninnenseite nach unten und außen geführt oder sind dort mit einer Steckverbindung versehen. Die Anschlüsse der Ventilgruppe für Behälterfüllung und -evakuierung 21 für das Beaufschlagen des Behälters mit Primärkühlmedium 13 liegt innerhalb der Tauchglockenkappe 15. Die Ventilgruppe befindet sich im Druckbehälter 14.

Die druckdichte Revisionsöffnung 20 befindet sich ebenfalls innerhalb der Tauchglockenkappe 15.

Die Elemente 20, 21 und 22 werden durch die Schutzatmosphäre unter der Tauchglockenkappe vor Umwelteinflüssen, insbesondere Korrosion, geschützt.

Der Lastanschlagspunkt 16 dient der Handhabung des Druckbehälters. Eine vertikale Mobilisierung (Auf- und Abtauchen) des Kühlbehältermoduls kann ebenfalls mittels Druckvariation des Behälterinnendrucks derart erfolgen, dass dieser als Tauchzelle funktioniert.

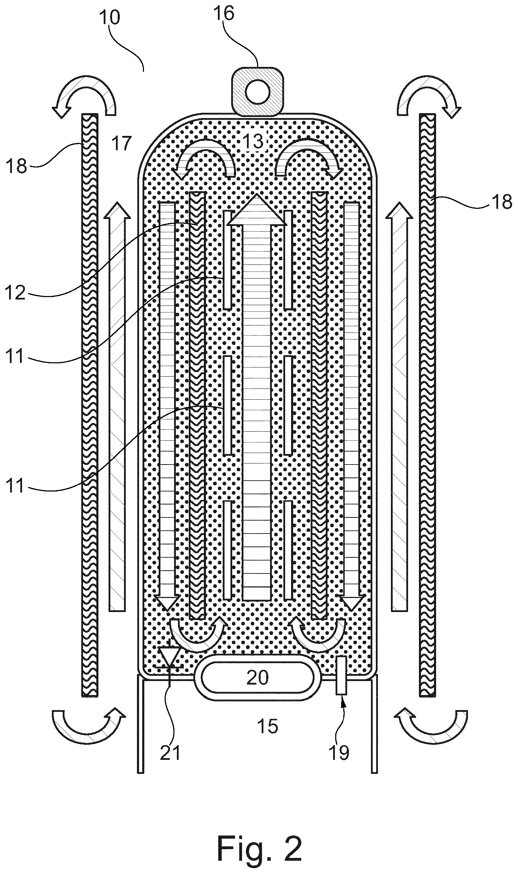

Fig. 2 zeigt eine schematische Schnittansicht einer Unterwasser-Kühlvorrichtung gemäß einem zweiten Ausführungsbeispiel. Die Ausgestaltung des Druckbehälters mit dem Kamininnenzug und dem Kaminaußenzug entspricht im Wesentlichen der Ausgestaltung des Druckbehälters mit dem Kamininnenzug und dem Kaminaußenzug von Fig. 1. Lediglich die elektrischen oder chemischen Wärmeerzeuger sind anders ausgestaltet.

Das Primärkühlmedium 13 wird durch die Verlustleistung der elektrischen Elemente 11 erwärmt und steigt im inneren, die Wärmeerzeuger 11 (z. B. die Leistungselektronik) umhüllenden Innenkaminschacht 12 auf und strömt an der inneren Druckbehälterwand 14a vorbei, so dass die Wandung 14a als Wärmetauscher fungiert. Dabei gibt die als Wärmetauscher fungierende Wandung 14a Wärme an das Sekundärkühlmedium 17, d. h. Seewasser, ab. Anschließend tritt das Primärkühlmedium 13 erneut in den Kamininnenschacht 12 ein. Der innere thermische Kreisprozess beginnt von neuem und unterhält eine kontinuierliche innere Strömung.

Das Sekundärkühlmedium 17 wird zwischen Druckbehälterwand 14a 14 und dem Mantel als Außenkaminzug 18 erwärmt. Es steigt innerhalb des Mantels 18 auf und führt die Verlustwärme der elektrischen Elemente an die Umgebung ab. Es bildet sich ein äußerer thermischer Kreisprozess aus.

Die Kühlbehältermodule werden in einem Köcherrahmen 24 aufgenommen. Behältermodule können verschiede elektrische Funktionen aufnehmen und zu einem Gesamtsystem in dem Köcherrahmen verschaltet werden.

In Fig. 2 wird insbesondere das Wirkprinzip der Kühlung näher beschrieben. Die durch die Wärmeerzeuger 11 erzeugte Wärme erhitzt das Primärkühlmitttel 13 innerhalb des Innenkaminzuges 12, so dass Wärme aufgrund des Kamineffektes nach oben steigt. Das erwärmte Primärkühlmittel 13 strömt nach oben und dann außerhalb des Kamininnenzuges entlang des Druckbehälters 14 nach unten und tauscht dabei Wärme mit der Außenwand des Druckbehälters 14 aus. Das Sekundärkühlmittel (beispielsweise Seewasser), welches innerhalb des Außenkaminzuges 18 und außen an der Wandung 14a des Druckbehälters 14 entlang fließt, nimmt Wärme von der Wandung 14a des Druckbehälters auf und kühlt somit die Wandung 14a des Druckbehälters 14. Dies führt wiederum zu einer Kühlung des Primärkühlmittels, welches entlang der Wandung 14a nach unten strömt.

Gemäß der Erfindung wird somit eine Unterwasser-Kühlvorrichtung vorgesehen, welche einen Außenkaminzug und einen Druckbehälter innerhalb des Außenkaminzuges aufweist. Innerhalb des Druckbehälters ist ein Innenkaminzug vorgesehen. Die zu kühlenden Wärmeerzeuger werden innerhalb des Innenkaminzuges angeordnet und der Druckbehälter wird mit einem Primärkühlmittel, insbesondere einem Gas, gefüllt.

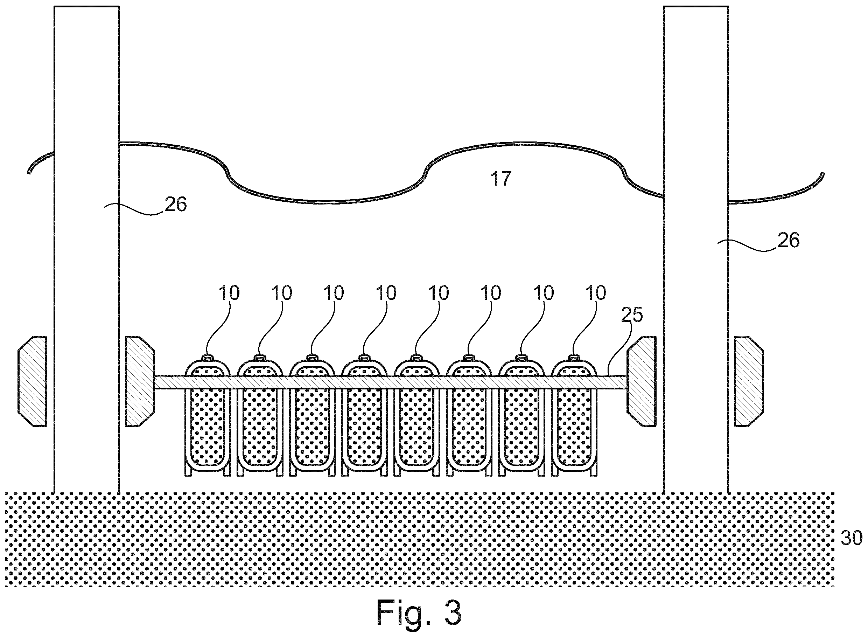

Fig. 3 zeigt eine schematische Darstellung eines Unterwasser-Kühlsystems gemäß einem dritten Ausführungsbeispiel. In Fig. 3 ist ein Kühlsystem gemäß einem dritten Ausführungsbeispiel gezeigt. Das Kühlsystem weist eine Mehrzahl von Unterwasser-Kühlvorrichtungen 10 auf, welche mit einem Verfahrsystem 25 gekoppelt sind. Das Verfahrsystem 25 wirkt mit zwei Monopiles 26 zusammen, um die Unterwasser-Kühlvorrichtungen 10 nach oben oder unten zu befördern. Die Monopiles 26 sind im Seebett 30 verankert.

Zum Überbrücken der Höhendistanz zwecks Austauschs wird ein Verfahrsystem 25 vorgesehen, das zwischen zwei Monopiles 26 vorgesehen sein kann, die wiederum im Boden 30 verankert sind.

Für manche chemische Verfahren kann es zwingend erforderlich sein, Luft von der Wasseroberfläche in den Prozess einzuleiten. Dafür kann ein Schnorchelsystem mit Druckerhöhungsvorrichtung (Kompressor) vorgesehen sein.

Gemäß einem Aspekt der Erfindung kann eine Sicherheitsleine zwischen Köcherrahmen und Kühlbehältermodul vorgesehen sein.

Gemäß einem Aspekt der Erfindung kann Kohlendioxid als Primärkühlmedium oder ein ähnlich bzw. gleichwertig wirkendes Gasgemisch verwendet werden.

Gemäß einem Aspekt der Erfindung kann der Kreisprozess des Primärkühlmittels mit einer Strömungseinheit 27 (z. B. einer Pumpe/ Turbine) unterstützt werden, um die Baugröße ggf. zu verkleinern.

Gemäß einem Aspekt der Erfindung kann der Druckbehälter mit einem authentischen Innenleiner (saures Medium) ausgebildet sein.

Gemäß einem Aspekt der Erfindung kann der Druckbehälter als zylindrische Röhre ausgeführt sein.

Gemäß einem Aspekt der Erfindung können die Medienanschlüsse (Elektrik und Medium) als fernbedienbare Schnellkupplungen ausgeführt sein.

Gemäß einem Aspekt der Erfindung können die Gesamtkapazität des Netzanschlusssystems oder die Prozessstufen der chemischen Verfahren auf mehrere Druckbehältermodule verteilt werden.

Gemäß einem Aspekt der Erfindung kann der Druckbehälter als Tauchzelle ausgebildet sein.

Gemäß einem Aspekt der Erfindung kann die Behälteraußen- und Innenwand mit Kühlrippen durchsetzt sein.

Gemäß einem Aspekt der Erfindung können die Köcherrahmen mit eigenen Tauchzellen/ Auftriebskörpern ausgestattet sein.

Gemäß einem Aspekt der Erfindung kann die Tauchglockenkappe geschlossen als zweite Barriere ausgebildet sein.

Zur Minimierung der Kabelbewegung und Dichtheit des Kabelschotts ist es vorteilhaft, das Kabel statisch vor dem Eintritt in die Tauchglockenkappe zu fixieren.

Für den getauchten Betriebszustand ist es vorteilhaft, ein Druckgefälle von innen nach außen aufzubauen mit der zwingenden Bedingung p(Tauchglockenkappe) > p (Umgebung = Hydrostatischer Druck).

Für das Betanken und Evakuieren der mit Gas befüllten Behälterteile ist es vorteilhaft, bei lotrechter Orientierung der Vorrichtung im Raum innenseitig am Behälterboden und an der Behälterdecke Aus- und Einströmventile vorzusehen.

Für eine Steckerlösung im Druckschott zwischen Kühldruckbehälter und Tauchglockenkappe ist eine Steckerkodierung vorteilhaft.

Der Köcherrahmen sollte als ein auf den Meeresboden absenkbares Element ausgebildet werden, wenn die Wassertiefe zur Bemessungswellenhöhe verhältnismäßig klein ist.

Der Köcherrahmen sollte für tiefe Gewässer unterhalb der Bemessungswellenhöhe mit einem Mooring System im Seewasser schwebend gehalten werden, ohne dass die Seeschifffahrt beeinträchtigt wird.

Der Köcherrahmen sollte für tiefe Gewässer auf den Meeresboden absenkbar sein, wenn Interessen der Landesverteidigung, z.B. Unterseebootrouten, beeinträchtigt sind.

Die erfindungsgemäße Unterwasserkühlvorrichtung kann durch Betreiber von Offshore-Netzanschlusssystemen und Offshore-Windparks verwendet werden, um erheblich Kosten für Herstellung und Betrieb zu reduzieren, sowie weitestgehend sicherheitsgerichtet Instandhaltungsarbeiten von See an Land zu verlagern. Aufgrund der erheblichen Vereinfachung des Kühlprinzips kann die Verfügbarkeit des Gesamtsystems gegenüber dem Stand der Technik bei entsprechender Auslegung z.B. 4 x 33,3% annähernd auf 100% ausgenommen von Umschaltzeiten gesteigert werden. Die Vorrichtung kann infolge der Druckbehälterinnenfüllung in sehr tiefen Gewässern auch außerhalb des Nordseeschelfs ohne nennenswerten Zuwachs der Behälterwanddicke eingesetzt werden.

Die erfindungsgemäße Unterwasserkühlvorrichtung kann durch Betreiber von Chemieanlagen verwendet werden, um Produktionsanlagen auf See auszulagern, damit beispielsweise Chemieparks aus Raumordnungsplanungsaspekten an Land anderen Nutzungen zugeführt werden können. Insbesondere steht die Sektorenkopplung von Energieerzeugung aus den Quellen Wind, Geothermie, Solar und Wellen und Erzeugung von chemischen Produkten im Mittelpunkt, um die Überproduktion aus vorgenannten unstetigen Quellen nutzbar zu machen.

Prozesse der Öl- und Gasindustrie im Offshore-Bereich können den elektrischen Eigenbedarf über Energie von Land oder beispielsweise Offshore-Windparks verwenden. Darüber hinaus kann die erfindungsgemäße Kühlvorrichtung zur Aufnahme von Verdichtern für den Pipelinetransport von Medien verwendet werden.

## Patentansprüche

1. Unterwasser-Kühlvorrichtung (10) zum Kühlen von elektrischen oder chemischen Wärmeerzeugern (11), mit einem Druckbehälter (14) mit einer Wandung (14a), einem ersten Ende (14b), einem zweiten Ende (14c), einem ersten Kaminschacht (12) innerhalb der Wandung (14a), einem Wärmeerzeuger-Aufnahmebereich (12a) innerhalb des ersten Kaminschachts (12) und einem Primärkühlmittel (13) innerhalb der Wandung (14a), **gekennzeichnet durch** einen zweiten Kaminschacht (18), wobei der zweite Kaminschacht (18) als ein Hohlzylinder ausgestaltet ist und sich außen um den Druckbehälter (14) herum erstreckt und wobei der zweite Kaminschacht (18) thermisch isoliert ist.

2. Unterwasser-Kühlvorrichtung (10) nach Anspruch 1, wobei der Druckbehälter (14) an dem ersten Ende (14b) eine Tauchglockenkappe (15) aufweist.

3. Unterwasser-Kühlvorrichtung (10) nach Anspruch 1 oder 2, wobei der Druckbehälter (14) an dem ersten Ende (14b) ein druckdichtes Kabelschott (19) für elektrische Kabel (22) aufweist.

4. Unterwasser-Kühlvorrichtung (10) nach einem der Ansprüche 1 bis 3, wobei der Druckbehälter (14) an dem ersten Ende (14b) eine druckdichte Revisionsöffnung (20) aufweist.

5. Unterwasser-Kühlvorrichtung (10) nach einem der Ansprüche 1 bis 4, wobei mindestens ein Wärmeerzeuger (11) in dem Wärmeerzeuger-Aufnahmebereich (12a) innerhalb des ersten Kaminschachts (12) angeordnet ist.

6. Unterwasser-Kühlvorrichtung (10) nach Anspruch 5, wobei der mindestens eine Wärmeerzeuger (11) einen elektrischen oder chemischen Wärmeerzeuger (11) darstellt.

7. Unterwasser-Kühlvorrichtung (10) nach einem der Ansprüche 1 bis 6, wobei das Primärkühlmittel (13) ein Inertgas, insbesondere CO2, darstellt.

8. Unterwasser-Kühlvorrichtung (10) nach einem der Ansprüche 1 bis 7, wobei der Druckbehälter (14) mindestens eine Strömungseinheit (27) zum Unterstützen einer Strömung des Primärkühlmittels (13) aufweist.

9. Unterwasser-Kühlvorrichtung (10) nach einem der Ansprüche 1 bis 8, wobei die Wandung (14a) des Druckbehälters (14) Innen- und/oder Außen-Kühlrippen (14d, 14e) aufweist.

10. Unterwasser-Kühlsystem, mit mindestens einer Unterwasser-Kühlvorrichtung nach einem der Ansprüche 1 bis 9, und einer Verfahrvorrichtung (25) zum Hochfahren oder Runterfahren der mindestens einen Unterwasser-Kühlvorrichtung (10).

## Claims

1. Underwater cooling device (10) for cooling electrical or chemical heat generators (11), having a pressure container (14) with a wall (14a), a first end (14b), a second end (14c), a first flue (12) within the wall (14a), a heat generator receiving region (12a) within the first flue (12) and a primary coolant (13) within the wall (14a), **characterized by** a second flue (18), wherein the second flue (18) is configured as a hollow cylinder and extends externally around the pressure container (14), and wherein the second flue (18) is thermally insulated.

2. Underwater cooling device (10) according to Claim 1, wherein the pressure container (14) has a diving-bell cap (15) at the first end (14b).

3. Underwater cooling device (10) according to Claim 1 or 2, wherein the pressure container (14) has a pressure-tight cable bulkhead (19) for electrical cables (22) at the first end (14b).

4. Underwater cooling device (10) according to one of Claims 1 to 3, wherein the pressure container (14) has a pressure-tight inspection opening (20) at the first end (14b) .

5. Underwater cooling device (10) according to one of Claims 1 to 4, wherein at least one heat generator (11) is arranged within the first flue (12) in the heat generator receiving region (12a).

6. Underwater cooling device (10) according to Claim 5, wherein the at least one heat generator (11) is an electrical or chemical heat generator (11).

7. Underwater cooling device (10) according to one of Claims 1 to 6, wherein the primary coolant (13) is an inert gas, in particular CO2.

8. Underwater cooling device (10) according to one of Claims 1 to 7, wherein the pressure container (14) has at least one flow unit (27) for supporting a flow of the primary coolant (13).

9. Underwater cooling device (10) according to one of Claims 1 to 8, wherein the wall (14a) of the pressure container (14) has internal and/or external cooling ribs (14d, 14e).

10. Underwater cooling system, having at least one underwater cooling device according to one of Claims 1 to 9, and a transfer device (25) for raising or lowering the at least one underwater cooling device (10).

## Revendications

1. Dispositif de refroidissement submersible (10) destiné à refroidir des générateurs de chaleur (11) électriques ou chimiques, comprenant un réservoir sous pression (14) pourvu d'une paroi (14a), d'une première extrémité (14b), d'une deuxième extrémité (14c), d'un premier conduit de cheminée (12) à l'intérieur de la paroi (14a), d'une zone d'accueil de générateur de chaleur (12a) à l'intérieur du premier conduit de cheminée (12) et d'un moyen de refroidissement primaire (13) à l'intérieur de la paroi (14a), **caractérisé par** un deuxième conduit de cheminée (18), le deuxième conduit de cheminée (18) étant réalisé sous la forme d'un cylindre creux et s'étendant autour à l'extérieur autour du réservoir sous pression (14) et le deuxième conduit de cheminée (18) étant isolé thermiquement.

2. Dispositif de refroidissement submersible (10) selon la revendication 1, le réservoir sous pression (14) possédant un chapeau de cloche d'immersion (15) au niveau de la première extrémité (14b).

3. Dispositif de refroidissement submersible (10) selon la revendication 1 ou 2, le réservoir sous pression (14) possédant, au niveau de la première extrémité (14b), une cloison étanche de câble (19) étanche à la pression pour un câble électrique (22).

4. Dispositif de refroidissement submersible (10) selon l'une des revendications 1 à 3, le réservoir sous pression (14) possédant, au niveau de la première extrémité (14b), une ouverture de révision (20) étanche à la pression.

5. Dispositif de refroidissement submersible (10) selon l'une des revendications 1 à 4, au moins un générateur de chaleur (11) étant disposé dans la zone d'accueil de générateur de chaleur (12a) à l'intérieur du premier conduit de cheminée (12).

6. Dispositif de refroidissement submersible (10) selon la revendication 5, l'au moins un générateur de chaleur (11) représentant un générateur de chaleur (11) électrique ou chimique.

7. Dispositif de refroidissement submersible (10) selon l'une des revendications 1 à 6, le moyen de refroidissement primaire (13) représentant un gaz inerte, en particulier du CO2.

8. Dispositif de refroidissement submersible (10) selon l'une des revendications 1 à 7, le réservoir sous pression (14) possédant au moins une unité d'écoulement (27) destinée à assister un écoulement du moyen de refroidissement primaire (13).

9. Dispositif de refroidissement submersible (10) selon l'une des revendications 1 à 8, la paroi (14a) du réservoir sous pression (14) possédant des ailettes de refroidissement intérieures et/ou extérieures (14d, 14e).

10. Système de refroidissement submersible, comprenant au moins un dispositif de refroidissement submersible selon l'une des revendications 1 à 9, et un dispositif de déplacement (25) destiné à faire monter ou à faire descendre l'au moins un dispositif de refroidissement submersible (10).
